# EUROPEAN PATENT APPLICATION

(11) **EP 3 490 149 A1**
(43) Date of publication of application: **29.05.2019**
(21) Application number: 17204081.8
(22) Date of filing: 28.11.2017
(51) Int. Cl.: H03K 19/003

(54) **ELECTRONIC CIRCUIT WITH RADIATION PROTECTED TMR FLIP FLOP**

(71) Applicant: IHP GmbH - Innovations for High Performance Microelectronics / Leibniz-Institut für innovative Mikroelektronik, 15236 Frankfurt (Oder) (DE)
(72) Inventor: SCHRAPE, Oliver, 13127 Berlin (DE); BREITENREITER, Anselm, 15236 Frankfurt (Oder) (DE); VATER, Frank, 03046 Cottbus (DE); KRSTIC, Milos, 15230 Frankfurt/Oder (DE)
(74) Representative: Eisenführ Speiser

(57) **Abstract**

An electronic circuit comprising a plurality of semiconductor components is suggested. The architecture of the electronic circuit is designed to be resistant against single event effects caused by high energy radiation. According to one embodiment the electronic circuit comprises three storage elements being composed of master-slave flip-flops. Each master-slave flip-flop includes a pair of a master latch (401-403) and a slave latch (406-408). The outputs of the storage elements are provided to a majority voter circuit (409). In order to make the electronic circuit more resistant against high energy radiation the master and slave latches (401-403; 406-408) of the storage elements are spatially separated from each other on a semiconductor chip.

## Description

### Field

The present invention relates to an electronic circuit comprising a plurality of electronic components. The architecture of the semiconductor circuit is designed to be resistant against single event effects caused by high energy radiation. The present invention also relates to an electronic device comprising an electronic circuit according to the invention.

### Background

It is a well-known fact that in the operation of integrated circuits so-called single-event effects (SEE) occur, which are caused by high energy radiation of ionizing particles, including for example charged particles or γ-particles. Often such radiation cannot be completely shielded in environments, such as in space, in nuclear reactors or particle accelerators. Single-event effects have a significantly lower frequency with respect to the frequency of their occurrence in comparison with a clock frequency of integrated circuits. Single-event effects are therefore regarded as individual events and not as simultaneous multiple occurrences.

In case a single-event effect occurs, it is in particular possible to undesirably switch a stored bit state, which is known as a single-event-upset (SEU). In addition, single-event latchups (SEL) are known, which manifest themselves in a short circuit of the operating voltage of the chip. The latchup effect is usually caused by a parasitic PNPN structure that corresponds to a parasitic thyristor structure and provides a conductive connection shortcutting the voltage supply via the electronic components. SEUs are significantly more frequent compared to SELs.

In order to prevent the in particular the relatively frequent SEUs or the malfunctions based on SEUs, certain redundant circuit designs are used in conventional circuits. A typical representative for SEU protection is the Triple-Modular-Redundancy (TMR) design, which will be described in greater detail further below.

An electronic circuit with a sequential logic circuit and a selection circuit connected downstream of the sequential logic circuit is known from DE 10 2006 055 867 A1. The selection circuit is used there in connection with a TMR design. The selection circuit is also referred to as a (majority) voter circuit in the context of the present application. The voter circuit receives the output signals from three parallel storage elements as input signals and generates an output signal corresponding to a majority of the three input signals. It is noted that the three parallel storage elements themselves receive nominally identical input signals. Consequently, in normal operation the output of the storage elements is identical. However, if an SEU occurs, the content of one of the storage elements is upset, i.e. it switches from "1" to "0" or vice versa. The output signal of the voter circuit is not affected because the other two storage elements still output the value "1". Hence, the majority of inputs received by the voter circuit are "1" and thus the output of the voter remains to be "1" as if no SEU had occurred. As a result the majority voter circuit protects the electronic circuit from outputting signals which are corrupted by an SEU.

Obviously, the TMR design is very useful in environments where electronic circuits have to be protected against radiation. However, there still remains a desire for increasing radiation protection of electronic circuit designs even further.

### Summary

According to a first aspect the present invention suggests an electronic circuit comprising a plurality of electronic components realized on a semiconductor chip. The electronic components are susceptible to single event effects. As a countermeasure to prevent data corruption by single event effects caused high energy radiation all electronic components are arranged spatially separated from each other on the semiconductor chip. Realizing the electronic components in different areas on the semiconductor chip makes it less likely that a single high energy particle impacts on several components at the same time.

In an advantageous embodiment the electronic components of the electronic circuit comprise at least three storage elements connected in parallel to receive nominally identical digital input signals and a clock signal. Each storage element is realized on the semiconductor chip and comprises a latch-based master-slave flip-flop. Each master-slave flip-flop includes a pair of a master latch and a slave latch. Each slave latch provides an output signal to a majority voter circuit, which is configured to generate a resulting output signal corresponding to the majority of the output signals of the slave latches. At least one pair of a master latch and a slave latch forming a storage element are spatially separated from each other on the semiconductor chip.

The separation of at least one pair of a master latch and a slave latch forming a storage element reduces the probability that a single particle hit causes multiple upsets. Obviously, the protection is improved when every pair of a master latch and a slave latch forming a storage element are spatially separated from each other on the semiconductor chip. As a result the electronic circuit as a whole is more resistant against high-energy radiation.

In the interest of hardening the electronic circuit against high-energy radiation it has been found useful when the spatially separated electronic components occupy different areas on a main surface of the semiconductor chip. Placing the electronic components in different areas on the main surface of the semiconductor chip provides for sufficient distance between electronic components that an impact of a high energy particle cannot lead to a multibit upset.

In one embodiment the electronic circuit comprises only one single inverter receiving the clock signal as an input signal and providing the inverted clock signal to the slave latches. The use of only a single inverter makes the design economically advantageous.

From the point of view of resistance against radiation the one single inverter is realized on the semiconductor chip on a location that is spatially separated from the master latches and the slave latches. The reason for doing so is the same as for the separation of the master latch and a slave latches, namely making it unlikely that a single particle hits multiple electronic components at the same time causing multiple single event effects.

In addition to that, the radiation protection is further improved if the inverter is realized according to a radiation hardened design.

In another embodiment of the electronic circuit the majority voter circuit is realized on the semiconductor chip on a location that is spatially separated from the master latches, the slave latches and/or the inverter.

Advantageously, the master latches, the slave latches and/or the inverter are located on the semiconductor chip in different rows. Placing the electronic components in different rows on the semiconductor chip makes more room available for accommodating the electrical connections to the electronic components.

In a particularly advantageous embodiment of the electronic circuit at least one master latch and at least one slave latch associated in a pair to form the same master-slave flip-flop circuit are not adjacently located on the semiconductor chip. For instance, in an embodiment of the electronic ciricuit electronic components are arranged in blocks which in turn are arranged on the main surface of the semiconductor chip in rows or columns, or rows and columns. The associated electronic components, such as for example a master latch and a slave latch associated in a pair to form the same master-slave flip-flop circuit, are arranged in different rows or different columns, or in different rows and columns on the semiconductor chip, with at least one other component in between them providing sufficient distance that in case of an impact of a high-energy particle prevents affecting both the master latch and the slave latch of the flip-flop circuit. It is particularly advantageous to place a decoupling cell between two functional components. Other arrangements of the electronic components are conceivable to realize the basic idea to provide sufficient distance between electronic components that an impact of a high energy particle cannot lead to a multibit upset. As a result, this design approach makes the electronic circuit less susceptible to single event effects due to high-energy particle impacts.

In yet another embodiment the electronic circuit comprises a further majority voter circuit receiving the output signals of the master latches as input signals and generating a resulting output signal corresponding to the majority of the output signals of the master latches, wherein the output of the further majority voter circuit is connected with the inputs of the slave latches. The further majority voter enables correction of even two single event upsets in the electronic circuit. This embodiment of the electronic circuit is particularly stable with regard to high-energy radiation.

As a further improvement of the last embodiment the further majority voter circuit is realized on the semiconductor chip on a location that is spatially separated from the master latches, the slave latches and/or the inverter. Separating the further majority voter reduces the probability that multiple electronic components are hit by a single high-energy particle.

According to a second aspect the present invention suggests an electronic device comprising an electronic circuit according to the first aspect of the present invention.

### Brief Description of Drawings

Exemplary embodiments of the present disclosure are illustrated in the drawings and are explained in more detail in the following description. In the figures the same or similar elements are referenced with the same or similar reference signs. It shows:
- Figure 1A: a circuit symbol of a clocked flip-flop;
- Figure 1B: the clocked flip-flop of Figure 1A in greater detail;
- Figure 2: a schematic block diagram of an embodiment of a triple modular redundancy (TMR) flip-flop;
- Figure 3: a schematic top view on the allocation of functional components of the TMR flip-flop shown in Figure 2 on a surface of a semiconductor chip;
- Figure 4: a block diagram of a first embodiment of a decomposed master-slave-latch based TMR flip-flop;
- Figure 5A: a schematic top view on a first allocation of functional components of the TMR flip-flop shown in Figure 4 on a surface of a semiconductor chip;
- Figure 5B: a schematic top view on a second allocation of functional components of the TMR flip-flop shown in Figure 4 on a surface of a semiconductor chip;
- Figure 6: a schematic block diagram of a second embodiment of a decomposed master-slave-latch based TMR flip-flop; and
- Figure 7: a schematic top view on the allocation of functional components of the TMR flip-flop shown in Figure 6 on the surface of a semiconductor chip.

### Description of Embodiments

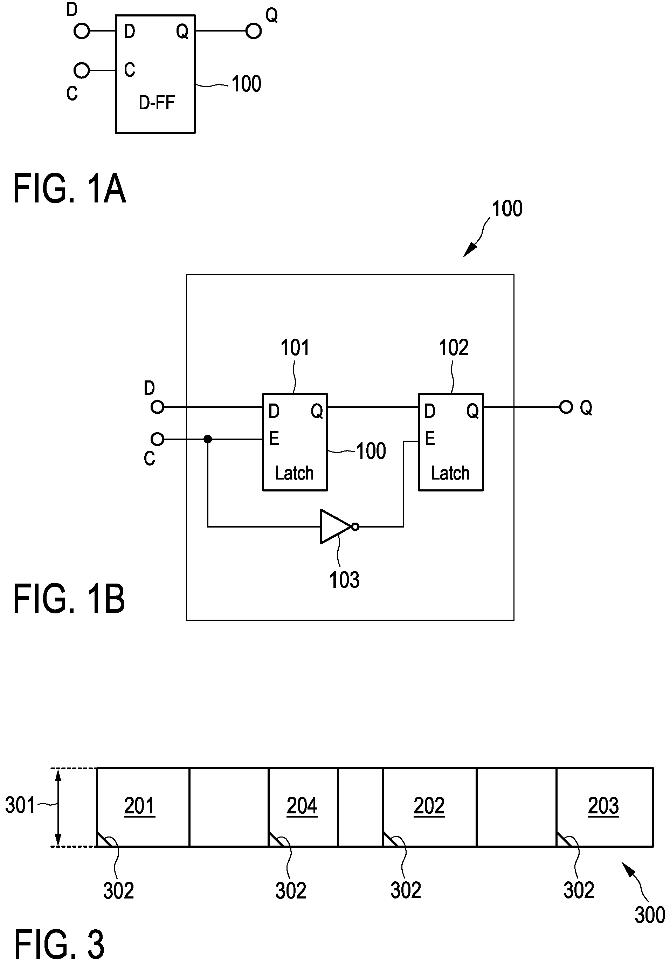

Figure 1A shows a circuit symbol of the flip-flop 100, which is designed as a non-transparent master slave flip-flop. The flip-flop 100 receives a data signal designated with the letter D and a clock signal designated with letter C. The output signal of the flip-flop 100 is designated with the letter Q. Corresponding inputs and the output of the flip-flop 100 are labelled with the same letters, namely C, D and Q. Frequently, flip-flops also provide a second output signal Q', which is complementary to the output signal Q. The present invention is applicable to flip-flops providing only the output signal Q as shown in Figure 1A as well as to flip-flops providing an output signal Q together with its complementary output signal Q'.

The flip-flop 100 of Figure 1A is shown in greater detail in Figure 1B. The flip-flop 100 is designed as a master-slave flip-flop, which is constructed from two separate flip-flops also referred to as D latches 101 and 102. The D latches 101 and 102 are also briefly denoted as "latches". In the circuit shown in Figure 1B latch 101 controls latch 102 which will become apparent in the following. Therefore, latch 101 is called master latch and latch 102 slave latch. The master latch 101 is enabled by a rising edge of the clock signal C provided to its enable input E. When the master latch 101 is enabled, the value of the data signal D is stored in the master latch and the value of the data signal appears at the output Q. The clock signal C is also provided to an inverter 103, the output of which is connected with an enable input E of slave latch 102. Hence, when the master flip-flop 101 is enabled by the rising edge of the clock signal C then the slave latch 102 is disabled by the output signal of the inverter 103 and vice versa.

The flip-flop 100 described so far works as follows. The information of the data signal D received at the data input D of the flip-flop 100 is transmitted to the master latch 101 when a rising edge of the clock signal C enables the master latch 101. The information of the data signal D, e.g. "1", is stored in the master latch 101 and appears at the output Q of master latch 101. While the information is stored in the master latch 101 the slave latch 102 is disabled. A falling edge of the clock signal C disables the master latch and enables the slave latch. The output Q of the master latch 101 is stored in the slave latch 102 while the master latch is disabled and no new data can be stored in the master latch 101. Only in the next clock cycle new information can be stored in the master latch 101 while the contents of the slave latch 102 remains unchanged. The flip-flop 100 works as a storage element for 1 bit.

The latches 101 and 102 can be constructed from two NAND gates or two NOR gates which are implemented as standard cells on a silicon wafer, for instance a p-doped silicon wafer or an n-doped wafer. In special applications other semiconductor material can be used, e.g. Ge, GaAS, InP etc. In any case the present invention is independent of what kind of semiconductor material is chosen to realize the electronic components.

An SEU that occurs in the master latch 101 or the slave latch 102 corrupts the output signal Q of the flip-flop 100. The same is true if an SEU occurs in the inverter 103 enabling the slave latch 102 when the master latch 101 is not yet disabled.

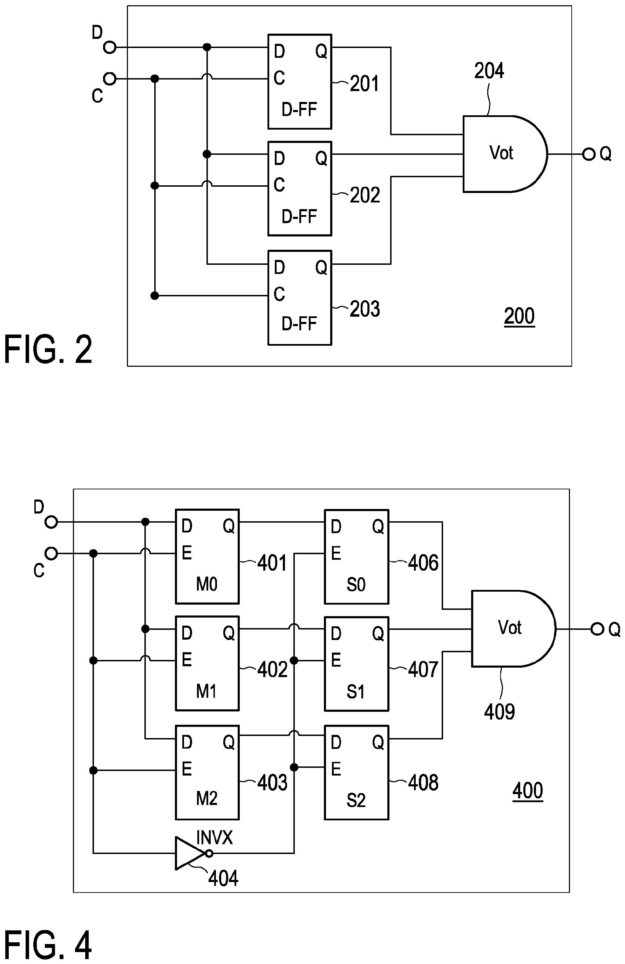

A conventional design approach for protecting flip-flop circuits against SEEs is called triple modular redundancy (TMR) flip-flop. A schematic block diagram of one embodiment of a TMR flip-flop 200 is shown in Figure 2. The TMR flip-flop 200 comprises three individual master slave flip-flops 201, 202, and 203 that represent storage elements that receive nominally identical data signals D. The clock signal C is equally provided to the master slave flip-flops 201, 202 and 203. The outputs Q of the master slave flip-flops 201, 202 and 203 are connected with a majority voter circuit 204. Each storage element 201, 202 and 203 is constructed like the flip-flop 100 shown in Figure 1B.

The functioning of the TMR flip-flop 200 and how it protects data against corruption by SEEs, in particular against SEUs, is explained by way of example. It is assumed that at any given moment the data signal D represents a "1". The rising edge of the clock signal C enables all master latches 101 of the storage elements 201, 202 and 203. At the same time, the corresponding slave latches 102 of the storage elements 201, 202 and 203 are disabled because the slave latches 102 receive an inverted clock signal C. When the falling edge of clock signal C disables the master latches 101, the slave latches 102 are enabled and at all outputs Q of the storage elements 201, 202, and 203 a signal "1" is available and provided to the majority voter circuit 204. Since the voter circuit 204 receives the same signal "1" at all inputs the voter circuit generates "1" as an output signal. The TMR flip-flop 200 works in the same way when the data signal D is "0". When no SEU occurs the TMR flip-flop 200 works in the same way as the simple flip-flop 100 shown in figure 1A. However, this is no longer the case when an SEU occurs.

Again, it is assumed that a data signal D being "1" is received at all inputs of storage elements 201, 202, and 203. But now an SEU occurs after the moment when the "1" of the data signal D is registered in the master latches and before the the slave latches 102 output the data in the next cycle of the clock signal. Without restriction of generality it is further assumed that caused by an SEU one of the output signals Q storage elements 201, 202, and 203 becomes "0" while the other two output signals remain "1". These different output signals Q are received at the inputs of voter circuit 204, which outputs a "1" because the majority of the received signals are still "1". In consequence, a single SEU in one of the storage elements 201, 202, and 203 has no impact on the output Q of the TMR flip-flop 200. In other words: The majority voter 204 protects the TMR flip-flop 200 against data corruption caused by an SEU.

In contrast to this result the simple flip-flop circuit 100 of Figure 1A is sensitive to an SEU. If a data signal D being "1" is received and an SEU occurs in the master latch 101 or the slave latch 102, then the output of flip-flop circuit 100 is "0".

This simple example demonstrates that the TMR flip-flop 200 is a radiation tolerant design, since even though an SEU had occurred, the TMR flip-flop 200 still outputs the correct signal. Only if two SEUs occur at the same time, for instance if a high-energy particle impacts on two storage elements, the TMR flip-flop 200 outputs also a corrupted result.

In a practical implementation of the TMR flip-flop 200 the storage elements 201, 202, and 203 are therefore spatially separated on a semiconductor chip to avoid or prevent multiple SEUs by a single particle hitting two storage elements. In modern chip design the storage elements 201, 202, and 203 are implemented as standard cells.

Figure 3 illustrates a top view on a typical design of the TMR flip-flop 200 on a semiconductor chip 300, for example p-doped silicon. The semiconductor chip or chip die 300 is a piece cut out of a semiconductor wafer. The top view shows a main surface of the semiconductor chip 300. The thickness of the semiconductor chip extends perpendicular to the drawing plane of Figure 3.

In Figure 3 the standard cells are symbolized by rectangles. The standard cells are arranged in a single row on the semiconductor chip that extends from left to right in Figure 3. The spatial separation of the standard cells reduces the probability that a single high-energy particle impacts at the same time on two or more of the components 201 to 204 of the TMR flip-flop 200. One disadvantage of the single row design shown in Figure 3, however, is that all connections leading the data signal D and the clock signal C to the storage elements 201-203 need to be routed in the same horizontal direction from the left or right side in Figure 3. The available room for the connections to the storage elements 201-203 is shown as a double-headed arrow 301. This spatial limitation puts additional constraints on the design of the semiconductor architecture for the TMR flip-flop 200. The standard cells shown in Figure 3 are realized for instance as metal - oxide - semiconductor (MOS) components on p-doped silicon (PMOS). In this design all components share the same well below the corresponding gates of the components. In consequence, the internal nodes of the storage elements are not protected. Thus, a single event upset may lead to a multibit upset, if adjacent storage elements are placed too close to each other.

Lines 302 in the corners of the standard cells 201-204 indicate the orientation of the standard cells. Specifically, the line 302 in lower left corner of a standard cell denotes a so called R0 orientation, i.e. the standard cell has not been rotated. The unlabelled areas between the standard cells 201-204 are empty cell areas, which remain available for fillers, decoupling cells ("decaps") or well-taps.

In order to further improve the performance of a TMR flip-flop with regard to radiation protection, an alternative design for a TMR flip-flop 400 is proposed as shown in Figure 4.

The TMR flip-flop 400 comprises three master latches 401, 402, and 403, which are also labelled as M0, M1, and M2. A data signal D is connected as input signal to the data inputs of all three master latches 401-403. A clock signal C is likewise connected to the enabling inputs of all three master latches 401-403. In addition to that, the clock signal C is provided to an inverter 404. The inverter 404 can be realized in a known RHBD ("radiation hardening by design") clock inverter. Furthermore, the TMR flip-flop 400 comprises three slave latches 406, 407 and 408, which are also labelled as S0, S1, and S2. The labels are chosen to denote that the output of master latch M0 is received as input by slave latch S0 etc. Each pair of associated master and slave latch M0/S0, M1/S1 and M2/S2 function together with the inverter 404 to form three independent master-slave flip-flops, wherein each master-slave flip-flop is operative as a storage element. The output of the inverter 404 is connected with enabling inputs E of the slave latches 406-408. In consequence, when the master latches 401-403 are enabled the slave latches 406-408 are disabled and vice versa. The outputs Q of the slave latches 406-408 are connected with a majority voter circuit 409 which generates an output signal Q corresponding to the majority of the received signals. I.e. if the majority of the outputs Q of the slave latches 406-408 output a signal value "1" then the output of the majority voter circuit 409 is also "1". Thus, the majority voter circuit 409 works in the same way as majority voter circuit 204 in the TMR flip-flop 200. Hence, the majority voter circuit 409 protects the output of the TMR flip-flop 400 against a single SEU occurring in any one of the components or internal nodes of the TMR flip-flop 400.

In comparison to the TMR flip-flop 200 shown in Figure 2 the TMR flip-flop 400 comprises only a single inverter 404 providing the inverted clock signal to all slave latches 406-408 while in the TMR flip-flop 200 shown in Figure 2 each storage element 201 to 203 is provided with one inverter 103 as it is shown in Figure 1B. In spite of this first structural difference the TMR flip-flop 400 functions in the same way as TMR flip flop 200 as it will be described below.

For illustrative purposes it is assumed that a data signal D having a value "1" is provided to the inputs D of all three master latches 401-403 in parallel. A clock signal C is connected to the enabling inputs of the master latches 401-403. The master latches 401-403 receive nominally identical input signals. The clock signal C is also provided to the inverter 404, the output of which is connected with enable inputs E of the slave latches 406-408. The master latches 401-403 are enabled by a rising edge of the clock signal C provided to their enable inputs E. When the master latches 401-403 are enabled, the value of the data signal D is stored in the master latches and the value of the data signal appears at their corresponding outputs Q. When the master latches 401-403 are enabled by the rising edge of the clock signal C then the slave latches 401-403 are disabled by the output signal of the inverter 404 and vice versa.

When a falling edge of clock signal C disables the master latches 401-403, the slave latches 102 are enabled and at all outputs Q of the master latches 401-403 are available as inputs to the slave latches 406-408 and are stored in the slave latches 406-408. The outputs of the slave latches 406-408 are provided to the majority voter circuit 409. Since the voter circuit 409 receives the same signal "1" at all inputs the voter circuit generates "1" as output signal. The TMR flip-flop 400 works in the same way when the data signal D is "0". When no SEU occurs, the TMR flip-flop 400 works in the same way as the simple flip-flop 100 shown in figure 1A.

If an SEU in any one of the master or slave latches 401-403 and 406-408, respectively, occurs then one of the outputs of these latches is upset from "1" to "0" in the above mentioned case that the data input signal D has a value "1". As a result, one of the output signals Q of the slave latches 406-408 is "0" while the other two output signals are "1". These different output signals Q are received at the inputs of voter circuit 409, which outputs a "1" because the majority of the received signals are still "1". In consequence, a single SEU in one of the master or slave latches 401-403 and 406-408, respectively, has no impact on the output Q of the voter circuit 409 and hence on the output of TMR flip-flop 400. In other words: The majority voter 409 protects the TMR flip-flop 400 against data corruption caused by an SEU.

Apparently, the mode of operation of the TMR flip-flops 200 and 400 are identical except that in TMR flip-flop 400 a single inverter 404 generates an inverted clock signal that is shared by all slave latches 406-408. The TMR flip-flops 200 and 400 also have in common that they can correct only one SEU. For instance, if an SEU occurs in the master latch 401 and a second SEU occurs in master latch 402 or 403 or in slave latches 407 and 408 the output of TMR flip-flop 400 is probably corrupted, i.e. a data signal with a value "1" at the input of TMR flip-flop 400 will be output as a value "0" because the voter circuit 409 receives two signal values "0" and only one signal value "1".

In addition to the structural difference with regard to the inverter 404, the TMR flip-flop 400 displays a second structural difference compared with the TMR flip-flop 200 shown in Figure 2, namely that the master latches 401-403 and the slave latches 406-408 are decomposed, i.e. they are spatially separated on the semiconductor chip. The decomposition of the master latches 401-403 and the slave latches 406-408 permits locating the components of for the TMR flip-flop 400 at different locations on a semiconductor chip.

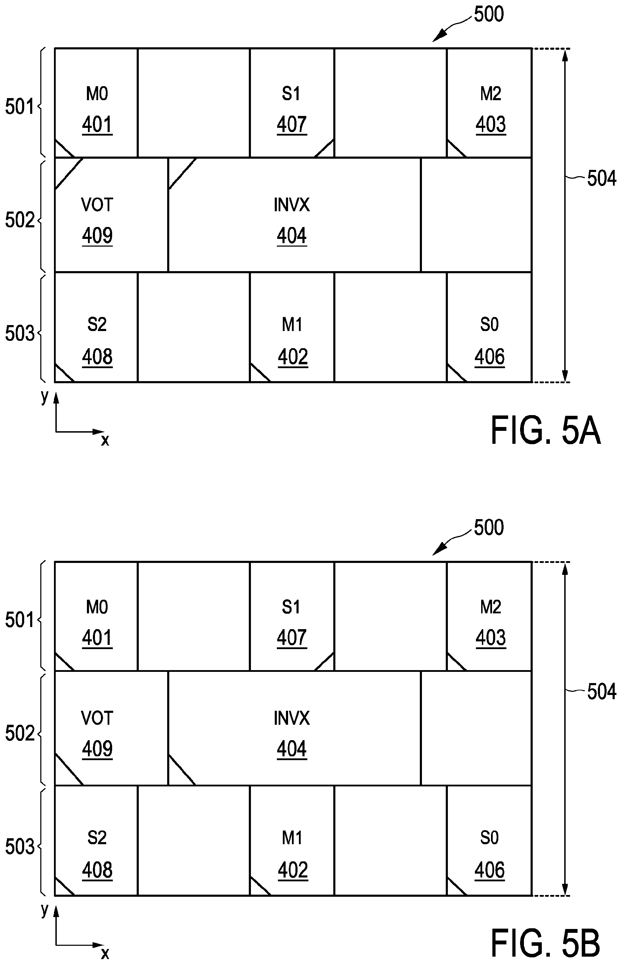

Figure 5A shows a top view on a main surface of a semiconductor chip or chip die 500, on which the components of the TMR flip-flop 400 are implemented. The semiconductor chip 500 is e.g. a p-doped silicon chip, on which the components are realized as MOS components. However, in other embodiments the semiconductor chip is an n-doped silicon chip. As illustrated, the components are arranged in three rows 501, 502, and 503. The associated pairs of master and slave latches M0/S0, M1/S1 and M2/S2 are arranged such that they are not geometrically adjacent on the semiconductor chip 500. Specifically, the first row 501 accommodates master latches M0 and M2 as well as slave latch S1. The third row 503 accommodates slave latches S0 and S2 as well as master latch M1. The second row 502 located in between the first and the third row 501 and 503, respectively, accommodates the voter circuit 409 and the inverter 404. It is, therefore, much less likely that a single high-energy particle impacts on to latches at the same time. In consequence, the TMR flip-flop 400 is even less sensitive to radiation than the TMR flip-flop 200. Furthermore, the three rows 501 to 503 provide for more space for horizontal signal connections then a single row standard cell placement as shown in Figure 3. The space that is available in the design of the TMR flip-flop 400 is indicated as double-headed arrow 504 in Figure 5.

It is also noted that the orientation of the standard cells implementing the components 401-404 and 406-409 are not the same. The orientation of each standard cell is symbolized by the location of the line 302 in each corresponding standard cell. If the line 302 is shown in the lower right corner it means the standard cell is mirrored along a Y-axis. If the line 302 is in the upper left corner it means the standard cell is mirrored along an X-axis. If the line 302 is in the upper right corner it means the standard cell is mirrored along an X-axis and a Y-axis. All these orientations make reference to the R0 orientation (line 302 in the lower left corner), in which the standard cell is not rotated.

Figure 5B displays a different layout of the standard cells on the chip die 500. In particular, the orientation of the standard cells implementing the inverter 404 and the voter circuit 409 have a different orientation than in the layout shown in Figure 5A. A different orientation of the standard cells or rows may require increasing the spatial separation between the standard cells by a couple of micrometers (µm).

In Figures 5A and 5B the unlabelled areas on the chip die 500 between the standard cells are again empty cell areas, which remain available for fillers, decaps or well-taps.

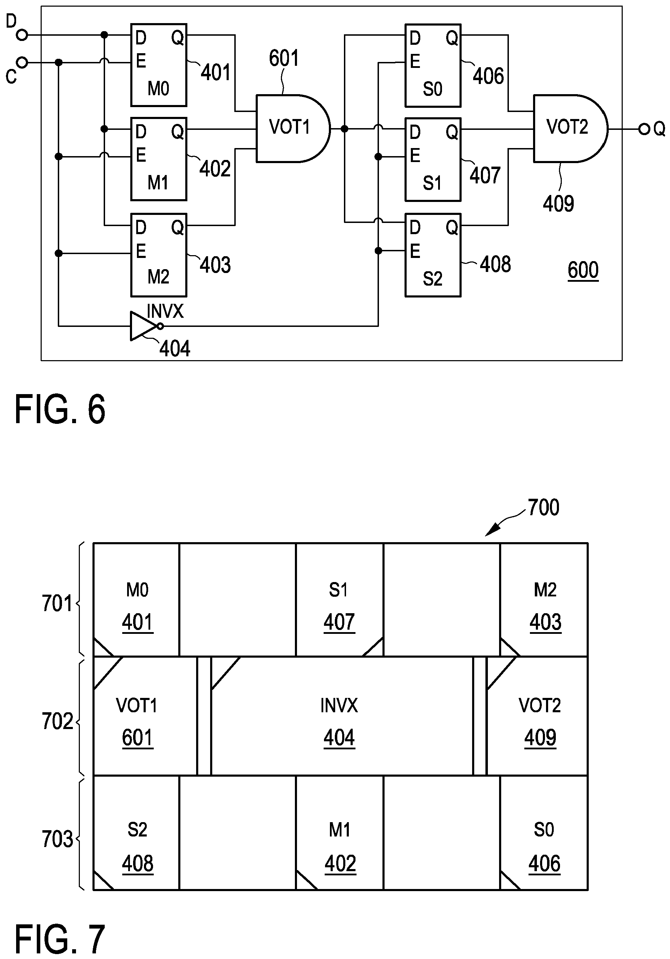

In Figure 6 another embodiment of a TMR flip-flop 600 is shown. In comparison with the TMR 400 flip-flop, the TMR flip-flop 600 comprises two majority voters. A first majority voter 601 receives the output signals of the master latches 401-403. A second majority voter 409 already known from the embodiment shown in Figure 4 receives the output signals of the slave latches 406-408. The first majority voter 601 works in the same way as the second majority voter 409, namely, it outputs a signal that corresponds to the majority of the received input signals. The first majority voter 601 corrects, therefore, any SEU that may occur in any one of the master latches 401-403. In addition to that, the second majority voter 409 corrects any SEU that may occur in one of the slave latches 406-408. That means that TMR flip-flop 600 can correct even two SEUs provided that one of them occurs in the master latches 401-403 and the second one occurs in the slave latches 406-408.

Figure 7 shows a top view on a main surface of a semiconductor chip 700 in which the functional components of the TMR flip-flop 600, including the master and slave latches, the inverter and the voting circuits, are implemented. As illustrated, the components are arranged in three rows 701, 702, and 703. The associated pairs of master and slave latches M0/S0, M1/S1 and M2/S2 are arranged such that they are not geometrically adjacent on the semiconductor chip. Specifically, the first row 701 accommodates master latches M0 and M2 as well as slave latch S1. The third row 703 accommodates slave latches S0 and S2 as well as master latch M1. The second row 702 located in between the first and the third row 701 and 703, respectively, accommodates the voters 409 and 601 as well as the inverter 404. Like it has been explained in the context TMR flip-flop 400 it is unlikely that a single high-energy particle impacts on to latches at the same time. Since the second voter circuit provides an increased correction capability the TMR flip-flop 600 is even less sensitive to radiation than the TMR flip-flop 400. The available space for horizontal connections is equally big then in that the design of the TMR flip-flop 400 shown in Figures 5A and 5B.

It is noted that the layout shown in Figure 7 is only one possible embodiment. Other layouts with a different orientation of one or more standard cell are equally feasible.

In the description of the embodiments master and slave latches latch are enabled or disabled by rising or falling edges of a clock signal. However, the invention is likewise applicable to latches that are enabled and disabled, respectively, by a corresponding state of the clock signal.

In the claims, the words "comprise" and "include" do not exclude other elements or steps, and the undefined article "a" does not exclude a plurality.

A single unit or device may perform the functions of several elements set forth in the claims. The fact that individual functions and elements are listed in different dependent claims does not mean that a combination of these functions and elements could not be used advantageously.

## Claims

1. Electronic circuit comprising a plurality of electronic components (201-204; 401-409) realized on a semiconductor chip (500) and being susceptible to single event effects, **characterized in that** all electronic components (201-204; 401-409) are arranged spatially separated from each other on the semiconductor chip (500).

2. Electronic circuit according to claim 1, wherein the electronic components comprise at least three storage elements (201-203) connected in parallel to receive nominally identical digital input signals (D) and a clock signal (C), wherein each storage element (201-203) is realized on the semiconductor chip (300; 500; 700) and comprises a latch-based master-slave flip-flop, wherein each master-slave flip-flop includes a pair of a master latch (401-403) and a slave latch (406-408), wherein each slave latch (406) provides an output signal (Q) to a majority voter circuit (409), which is configured to generate a resulting output signal corresponding to the majority of the output signals of the slave latches (406-408), wherein at least one pair of a master latch and a slave latch forming a storage element are spatially separated from each other on the semiconductor chip (300; 500; 700).

3. Electronic circuit according to claim 1 or 2, wherein the spatially separated electronic components occupy different areas on a main surface of the semiconductor chip (300; 500; 700).

4. Electronic circuit according to claim 2 or 3 further comprising one single inverter (404) receiving the clock signal (C) as an input signal and providing the inverted clock signal to the slave latches (406-408).

5. Electronic circuit according to claim 4, wherein the one single inverter (404) is realized on the semiconductor chip (300; 500; 700) on a location that is spatially separated from the master latches (401-403) and/or the slave latches (406-408).

6. Electronic circuit according to claim 4, wherein the inverter (404) is realized according to a radiation hardened design.

7. Electronic circuit according any one of claims 2 to 6, wherein the majority voter (409) circuit is realized on the semiconductor chip (300; 500; 700) on a location that is spatially separated from the master latches (401-403), the slave latches (406-408) and/or the inverter (404).

8. Electronic circuit according to any one of the preceding claims, wherein the master latches (401-403), the slave latches (406-408) and/or the inverter (404) are located on the semiconductor chip (500; 700) in different rows (501-503; 701-703).

9. Electronic circuit according to any one of the preceding claims, wherein at least one master latch (401-403) and at least one slave latch (406-408) associated in a pair to form the same master-slave flip-flop circuit are not adjacently located on the semiconductor chip (500; 700).

10. Electronic circuit according any one of the preceding claims comprising a further majority voter circuit (601) receiving the output signals of the master latches (401-403) as input signals and generating a resulting output signal corresponding to the majority of the output signals of the master latches (401-403), wherein the output of the further majority voter circuit (601) is connected with the inputs of the slave latches (406-408).

11. Electronic circuit according to claim 10, wherein the further majority voter circuit (601) is realized on the semiconductor chip (700) on a location that is spatially separated from the master latches (401-403), the slave latches (406-408) and/or the inverter (404).

12. Electronic device comprising an electronic circuit according to any one of the preceding claims.
